# EUROPEAN PATENT SPECIFICATION

(11) **EP 3 203 512 B1**
(45) Date of publication and mention of the grant of the patent: **08.05.2019**
(21) Application number: 16154626.2
(22) Date of filing: 08.02.2016
(51) Int. Cl.: H01L 23/36, H01L 23/46, H01L 23/473, H01L 23/427

(54) **HEAT SPREADER AND POWER MODULE**
WÄRMEVERTEILER UND LEISTUNGSMODUL
DISSIPATEUR DE CHALEUR ET MODULE DE PUISSANCE

(43) Date of publication of application: 09.08.2017
(73) Proprietor: ABB Schweiz AG, 5400 Baden (CH)
(72) Inventor: Agostini, Bruno, 8006 Zürich (CH); Kearney, Daniel, 8004 Zürich (CH); Torresin, Daniele, 5413 Birmenstorf (CH); Agostini, Francesco, 8005 Zürich (CH); Habert, Mathieu, 68170 Rixheim (FR)
(74) Representative: ABB Patent Attorneys

(56) References cited:
- EP-A1- 2 031 332
- CN-B- 101 886 801
- JP-A- 2002 081 874
- JP-A- 2005 308 358
- JP-A- 2009 076 622

## Description

### FIELD OF THE INVENTION

The invention relates to a heat spreader comprising a base plate for receiving a heat load from at least one electric component, the base plate including pulsating heat pipes for fluid flow arranged therein. The invention relates also to a power module.

### BACKGROUND OF THE INVENTION

While increasing the heat transfer coefficient is critical for improved cooling it is not a panacea. Reducing chip sizes and increasing heat fluxes means the heat spreading performance of the layers between the heat sources becomes more important to smooth out heat flux peaks, conduct the heat laterally and reduce the global chip temperature in the electronic package.

Heat spreading is very effective way of mitigating the need for sophisticated high-heat flux cooling options. Of course, to be effective the benefits of decreasing the heat flux density by increasing the area should outweigh the penalty of adding another layer that the heat must be conducted across. Combining heat spreader with standard cooling methods significantly increases the cooling performances.

Ideally heat spreaders are passive and can be either solid conductors ranging from standard copper to more exotic enhanced materials as pyrolytic graphite, e.g. k-core™ from Thermocore, or two-phase heat spreaders such as vapour chambers and pulsating heat pipes.

A pulsating heat pipe is a heat transfer device that consist of a metallic tube of capillary dimensions wound in a serpentine manner and joined end to end. It is first evacuated and then filled partially with a working fluid which distributes itself naturally in the form of liquid-vapour plugs and slugs inside the capillary tube. Typically one end of this bundle of tubes receives heat (evaporator section) transferring it to the other end (condenser section) by a pulsating action of the liquid-vapour system.

The document JP2009076622 discloses a heat sink that can convey much heat by continuously using evaporation heat. A wick is formed so that capillary tube force may occur mainly in a vertical direction.

The document JP2005308358 discloses a heat transfer device using a heat pipe capable of starting operation without using external power.

A known structure to perform heat spreading for power applications includes grooves machined in the base plate of a classical heatsink. Heat pipes are inserted and flattened inside these grooves. The thermal contact between the heat pipes and the heatsink is usually obtained by adding a thermal interface material or simply by the contact obtained by the flattening process.

There are several limitations with this technology. Only small diameter heat pipes can be used thus limiting the maximum power transported by each heat pipe. Each heat pipe has to be located below hotspot and has to avoid the screw holes so that the design has to be changed for each application. There is an additional thermal resistance between the heat pipe and the cooler base plate (epoxy or resin layer). Possible galvanic corrosion may be present between aluminium and copper in humid environment (outdoor applications).

### SUMMARY OF THE INVENTION

An object of the present invention is to improve the homogeneity of the heat flux of the base plate of the heat spreader and to solve the above mentioned problems. The objects of the invention are achieved by a heat spreader as recited in claim 1. The base plate has a first side, and a second side which is opposite to the first side; the pulsating heat pipes comprise a plurality of multichannel heat tubes which are embedded side by side on the first side of the base plate; and the second side of the base plate is provided for attaching the electric components.

The invention is based on the idea of providing a planar and low cost orientation-free heat spreader out of brazable multiport tubes compatible with mass production which heat spreader is capable of coping with high density power modules.

An example not claimed is where a trough extending perpendicularly to the first side is formed for the heat tubes on the first side of the base plate, the trough having borders the height of which corresponding to the height or the thickness of the embedded heat tubes, wherein two opposite borders of the trough and corresponding multiport ends of the heat tubes form adjacent flow spaces between adjacent heat tubes or channels of the heat tubes and wherein these flow spaces on the opposite sides of the trough are laterally offset to each other thereby creating a serpentine-like flow path between adjacent heat tubes or channels of the heat tubes for pulsating heat pipe function.

One preferred embodiment of the invention is where a trough extending perpendicularly to the first side is formed for the heat tubes on the first side of the base plate, the trough having borders the height of which corresponding to the height or the thickness of the embedded heat tubes, wherein two opposite borders of the trough and corresponding multiport ends of the heat tubes form adjacent flow spaces between two adjacent heat tubes at a time and wherein a lateral distance between two adjacent flow spaces corresponds to the width of two heat tubes and wherein these flow spaces on the opposite sides of the trough are laterally offset to each other for an amount which corresponds to the width of one heat tube thereby creating a serpentine-like flow path between adjacent heat tubes for pulsating heat pipe function.

In the present invention the hotspot area with high heat density losses can be located to a middle section of the base, i.e. in the middle section of the multichannel heat tubes, wherein this middle section is an evaporation area and two opposite sides of the base plate form condensation areas. This configuration will generate the pulsation of fluid inserted and contained in the system that will spread heat from the center to the sides of the base plate.

Key benefits of the present invention are manufacturability, possibility to retrofit to a number of aluminium heat sinks, cost effectiveness and lightweight structure. Further key benefits are that it can enhance the performance of existing solutions enabling higher current densities and power levels; larger diameters and more concentration of channels can be used thus increasing the maximum power transported by each heat pipe compared to state of the art; no galvanic corrosion is present in humid environments (outdoor applications); negligible additional thermal resistance can be obtained when adding a cooler to the spreader.

The power module according to the invention is recited in claim 7.

### BRIEF DESCRIPTION OF THE DRAWINGS

In the following the present invention will be described in greater detail by means of preferred embodiments with reference to the attached drawings, in which
Figure 1 shows a side view of a first embodiment of a heat spreader;
Figure 2 shows a front view of the first embodiment of the heat spreader;
Figure 3 shows a cross sectional view according lines C - C of Figure 1;
Figure 4 shows a side view of a second embodiment of a heat spreader;
Figure 5 shows a front view of the second embodiment of the heat spreader;
Figure 6 shows a cross sectional view according lines C' - C' of Figure 4;
Figure 7 shows a detail of the second embodiment in a perspective view; and
Figure 8 a combination of the heat spreader of the present invention and a heat exchanger.

### DETAILED DESCRIPTION OF THE INVENTION

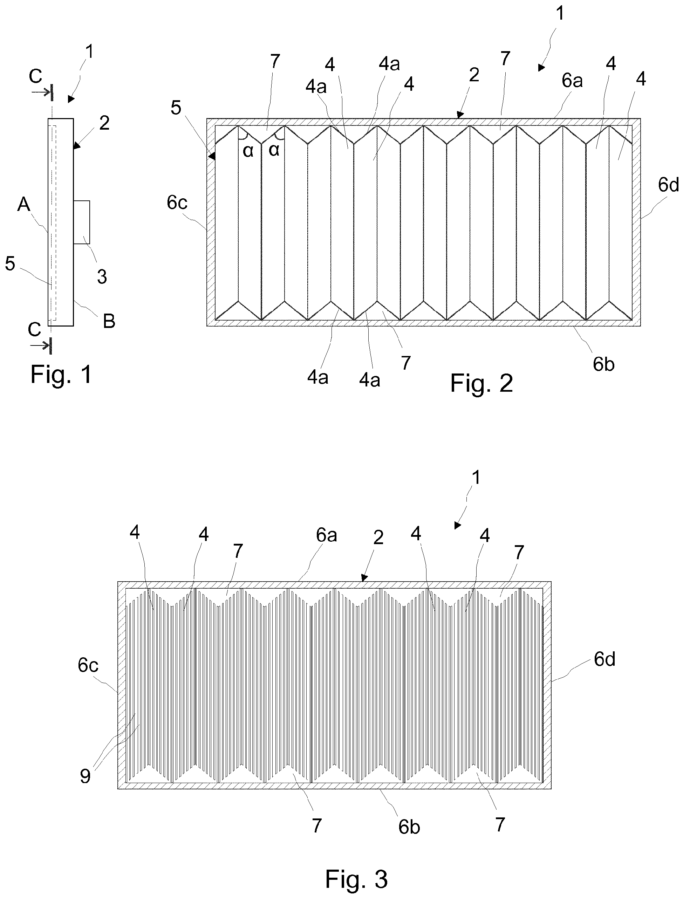

Figures 1 to 3 illustrate a first embodiment of the heat spreader 1. It comprises a base plate 2 for receiving a heat load from at least one electric component 3 and has a first side A, and a second side B which is opposite to the first side A. The heat spreader 1 or the base plate 2 further comprises a plurality of multichannel heat tubes 4 which are embedded side by side on the first side A of the base plate 2. As figure 1 shows, the second side B of the base plate 2 is provided for attaching the electric components 3.

For embedding the heat tubes 4, a trough 5, e.g. by machining, extending perpendicularly to the first side A is formed on the first side A of the base plate 2. The depth of the trough 5 corresponds to the height or the thickness of the embedded heat tubes 4 and consequently the trough 5 has borders 6a, 6b, 6c and 6d the height of which similarly corresponds to the height or the thickness of the embedded heat tubes 4. Two opposite borders 6a and 6b of the trough 5 and corresponding multiport ends 4a of the heat tubes form adjacent flow spaces 7 between two adjacent heat tubes 4 at a time. A lateral distance between two adjacent flow spaces 7 corresponds to the width of two heat tubes 4 and these flow spaces 7 on the opposite sides of the trough 5 are laterally offset to each other for an amount which corresponds to the width of one heat tube 4, thereby creating a serpentine-like flow path between adjacent heat tubes 4 for pulsating heat pipe function. In other words, these flow spaces 7 serve as a header for establishing a fluid connection between two neighboring heat tubes 4 in a lateral direction when seen in the direction perpendicularly to the first side A.

In the embodiment of Figures 1 to 3 the through 5 is rectangular and the ends 4a of the heat tubes 4 have cut ends 4a with an angle α, e.g. 45°, when seen in a direction perpendicularly to the first side. Both cut ends 4a on each heat tube have essentially same cutting angle, i.e. the cut ends 4a are parallel to each other on both ends 4a, wherein by alternating orientation of two adjacent heat tubes, triangular flow spaces 7 are formed between two opposite, essentially straight borders 6a and 6b of the trough 5 and corresponding angled cut ends 4a of the heat tubes 4, thereby creating a serpentine-like flow path between adjacent heat tubes 4 for pulsating heat pipe function. This embodiment requires a minimal machining of the base plate 4 but on the other hand requires special cut heat tubes 4.

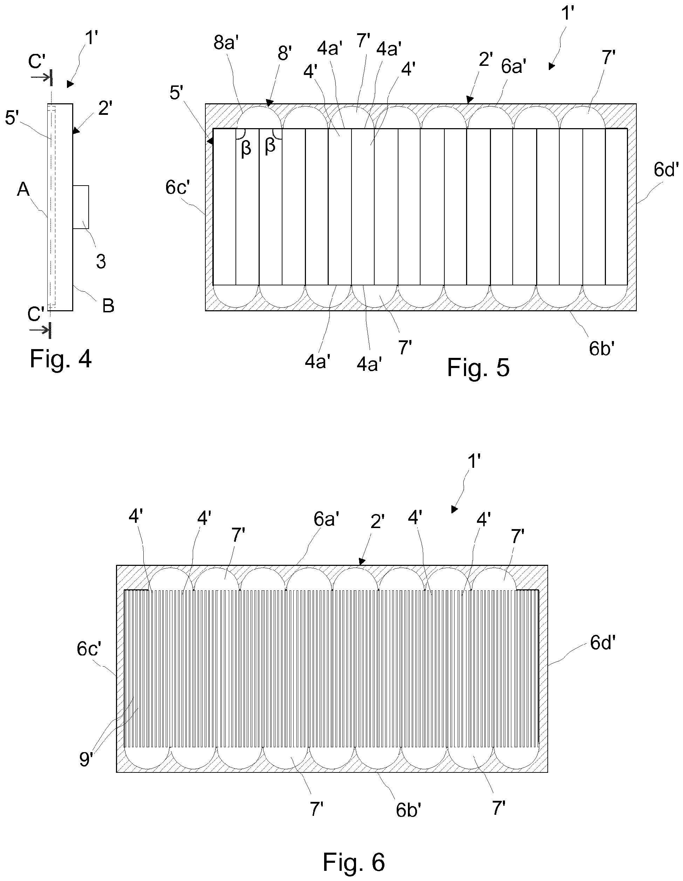

Figures 4 to 6 illustrate a second embodiment of the heat spreader 1'. It comprises a base plate 2' for receiving a heat load from electric components 3 and has a first side A, and a second side B that is opposite to the first side A. The heat spreader 1' or the base plate 2' further comprises a plurality of multichannel heat tubes 4' which are embedded side by side on the first side A of the base plate 4'. As figure 4 shows, the second side B of the base plate 2' is provided for attaching the electric components 3'.

For embedding the heat tubes 4', a trough 5', e.g. by machining, is formed on the first side A of the base plate 2'. The depth of the trough 5' corresponds to the height or the thickness of the embedded heat tubes 4' and consequently the trough 5' has borders 6a', 6b', 6c' and 6d' the height of which similarly corresponds to the height or the thickness of the embedded heat tubes 4'. Two opposite borders 6a' and 6b' of the trough 5' and corresponding multiport ends 4a' of the heat tubes form adjacent flow spaces 7' between two adjacent heat tubes 4' at a time and these flow spaces 7' on the opposite sides of the trough 5' are laterally offset to each other for an amount which corresponds to the width of one heat tube 4', thereby creating a serpentine-like flow path between adjacent heat tubes 4' for pulsating heat pipe function. In other words, these flow spaces serve as a header for establishing a fluid connection between two neighboring heat tubes 4 in a lateral direction when seen in the direction perpendicularly to the first side A.

In the embodiment of Figures 4 to 6 the ends 4a' of the heat tubes 4' are cut at right angle β perpendicularly to a longitudinal direction defined by the heat tubes 4' when seen in a direction perpendicularly to the first side A, i.e. at an angle of 90°, and the corresponding opposite borders 6a' and 6b' of the trough 5' have recesses 8' the width of each recess 8' corresponding essentially the width of two heat tubes 4'. Here the flow spaces 7' are formed between these recesses and corresponding straight cut ends 4a' of the heat tubes 4', thereby creating a serpentine-like flow path between adjacent heat tubes 4' for pulsating heat pipe function. Preferably each recess has a wall 8a' which is a sector of a cylinder when seen in a direction perpendicularly to the first side A. This enables easy machining of the recesses 8'. However, this embodiment requires more machining of the base plate 2' but on the other hand can be made "off the shelf" MPE tubes.

In both embodiments each heat tube 4; 4' is an extruded flat tube which preferably has one layer of juxtaposed capillary dimensioned channels 9; 9'. The cross-sectional area of a channel which is considered capillary depends on the fluid that is used (boiling) inside. For fluids suitable for use in the illustrated heat spreader the cross-sectional area of a channel which is can be considered capillary dimensioned is about 2.5 mm² or less in an exemplary embodiment. Aluminium is one preferred material for the heat tubes 4; 4'. One embodiment is a multiport extruded conduit for the heat tubes 4; 4'. Heat tubes 4; 4' are kept in place within the through 5; 5' e.g. by press-fit, gluing or soldering.

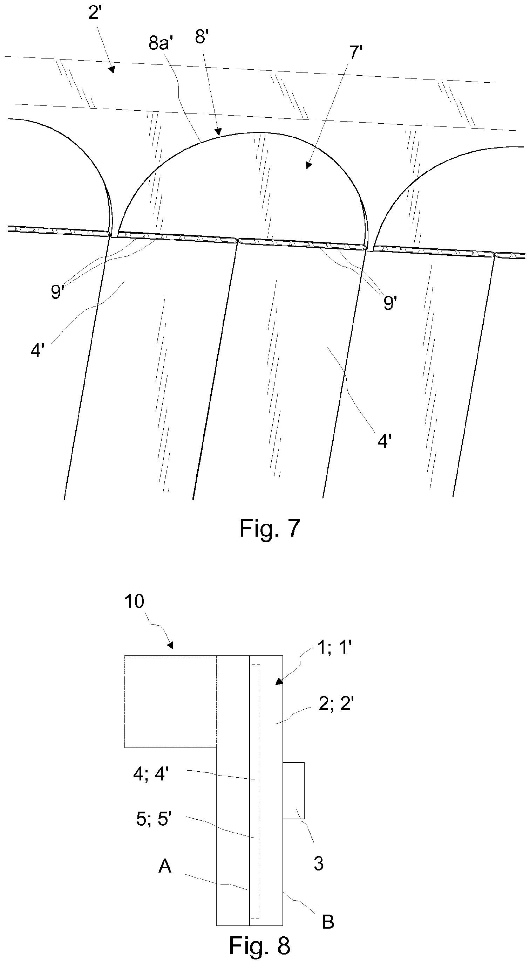

For enabling above mentioned pulsating heat pipe function in both embodiments, the first sides A of the base plates 2 comprising the heat tubes 4; 4' must be hermetically sealed. It can be sealed by a simple plate, but for enabling an efficient cooling it is closed by a heat exchanger 10, as shown in Figure 8. The heat exchanger can be e.g. air heat sink, water cooler and passive two-phase cooling system.

When electric components 3 are attached to the middle section of the second side B of the base plate 2: 2' the middle section of the base plate 2; 2' performs a function of an evaporator, wherein heat transfer fluid contained in the capillary sized channels 9; 9 will transfer heat to the borders (condensation area) of the base plate 2; 2', where through the flow spaces 7 cooled heat transfer fluid can enter back to the channels 9; 9' of the heat tubes 4, 4' for continuing the pulsating heat pipe function.

When one or more electric components 3 are attached to the second side B of the base plate 2; 2' it provides a power module where the electric components 3 are thermally connected to the base plate 2; 2'. Typically a heat exchanger as described above is attached directly or indirectly, e.g. by brazing to the first side A.

It is to be understood that the above description and the accompanying Figures are only intended to illustrate the present invention. Its will be obvious to a person skilled in the art that the invention can be varied and modified without departing from the scope of the invention as defined in the claims.

## Claims

1. A heat spreader (1; 1'), comprising:
a base plate (2; 2') for receiving a heat load from at least one electric component (3), the base plate including pulsating heat pipes (4; 4') for fluid flow arranged therein, wherein
the base plate (2; 2') has a first side (A), and a second side (B) which is opposite to the first side (A);
the pulsating heat pipes comprise a plurality of multichannel heat tubes (4; 4') which are embedded side by side on the first side (A) of the base plate (2; 2'); and
the second side (B) of the base plate (2; 2') is provided for attaching the electric components (3),
a trough (5; 5') extending perpendicularly to the first side (A) is formed for the heat tubes (4, 4') on the first side (A) of the base plate (2, 2')), the trough (5; 5') having borders (6a, 6b, 6c, 6d; 6a', 6b', 6c', 6c') the height of which corresponding to the height or the thickness of the embedded heat tubes (4; 4'), wherein two opposite borders (6a, 6b; 6a', 6b') of the trough (5; 5') and corresponding multiport ends (4a; 4a') of the heat tubes (4; 4') form adjacent flow spaces (7; 7') between two adjacent heat tubes (4, 4') at a time and wherein a lateral distance in between two adjacent flow spaces (7; 7') corresponds to the width of two heat tubes (4; 4'), and wherein these flow spaces (7; 7') on the opposite sides (6a, 6a') of the trough (5; 5') are laterally offset to each other for an amount which corresponds to the width of one heat tube (4; 4') thereby creating a serpentine-like flow path between adjacent heat tubes (4; 4') for pulsating heat pipe function,
**characterized in that**.
the trough (5) is rectangular and the ends (4a) of the heat tubes (4) having cut ends (4a) with an angle when seen in a direction perpendicularly to the first side (A), both cut ends (4a) on each heat tube (4) having essentially same cutting angle, wherein by alternating orientation of two adjacent heat tubes (4), triangular connection or flow spaces (7) are formed between two opposite, essentially straight borders (6a, 6a) of the trough (5) and corresponding angled cut ends (4a) of the heat tubes (4), thereby creating a serpentine-like flow path between adjacent heat tubes (4) for pulsating heat pipe function, or
the ends (4') of the heat tubes (4) are cut at right angle(β) perpendicularly to a longitudinal direction defined by the heat tubes (4') when seen in a direction perpendicularly to the first side (A)) and the corresponding opposite borders (6a', 6b') of the trough (5) have recesses (8') the width of each recess (8') corresponding essentially to the width of two heat tubes (4'), wherein the connection or flow spaces (7') are formed between these recesses (8') and corresponding straight cut ends (4a') of the heat tubes (4'), thereby creating a serpentine-like flow path between adjacent heat tubes (4') for pulsating heat pipe function.

2. The heat spreader according to claim 1, wherein
each recess (8') has a wall (8a') which is a sector of a cylinder when seen in a direction perpendicularly to the first side (A).

3. The heat spreader according to one of claims 1 or 2, wherein
each heat tube (4; 4') is an extruded flat tube which has one layer of juxtaposed capillary dimensioned channels (9; 9').

4. The heat spreader according to one of claims 1 to 3, wherein the heat tubes (4; 4') are multiport extruded conduits.

5. The heat spreader according to one of claims 1 to 4, wherein
the first side (A) of the base (2; 2') plate containing the heat tubes (4; 4') is arranged to be hermetically sealed.

6. The heat spreader according to one of claims 1 to 5, wherein
the first side (A) of the base plate (2; 2') containing the heat tubes (4; 4') is arranged to be attached to a heat exchanger which closes the first side (A) of the base plate (2; 2'), the heat exchanger being selected from a group containing at least air heat sink, water cooler and passive two-phase cooling system.

7. Power module comprising a heat spreader according to any one of the previous claims, wherein an electric component (3) is attached to the second side (B) of the base plate (2; 2') such that the electric component is thermally connected to the base plate (2; 2'); and wherein a heat exhanger is thermally attached to the first side (A).

## Patentansprüche

1. Ein Wärmeverteiler (1; 1), Folgendes umfassend; eine Grundplatte (2; 2') zum Aufnehmen einer Wärmelast von mindestens einem elektrischen Bauteil (3), wobei die Grundplatte pulsierende Wärmerohre (4; 4') für die darin angeordnete Fluidströmung einschließt, wobei die Grundplatte (2; 2') eine erste Seite (A) und eine zweite Seite (B), die der ersten Seite (A) gegenüberliegt, aufweist;
die pulsierenden Wärmerohre mehrere Mehrkanalwärmerohre (4; 4') umfassen, die nebeneinander auf der ersten Seite (A) der Grundplatte (2; 2') eingelassen sind; und
die zweite Seite (B) der Grundplatte (2; 2') zum Befestigen der elektrischen Bauteile (3) bereitgestellt ist, eine Wanne (5; 5'), die sich senkrecht zu der ersten Seite (A) erstreckt, auf der ersten Seite (A) der Grundplatte (2, 2') für die Wärmerohre (4, 4') ausgebildet ist, wobei die Wanne (5; 5') Kanten (6a, 6b, 6c, 6d; 6a', 6b', 6c', 6c') aufweist, deren Höhe der Höhe oder Stärke der eingelassenen Wärmerohre (4; 4') entspricht, wobei zwei gegenüberliegende Kanten (6a, 6b; 6a', 6b') der Wanne (5; 5') und zugehörige Mehrfachanschlussenden (4a; 4a') der Wärmerohre (4, 4') gleichzeitig angrenzende Strömungsräume (7; 7') zwischen zwei angrenzenden Wärmerohren (4, 4') ausbilden und wobei ein lateraler Abstand zwischen zwei angrenzenden Strömungsräumen (7; 7') der Breite von zwei Wärmerohren (4; 4') entspricht und wobei die Strömungsräume (7; 7') auf den gegenüberliegenden Seiten (6a, 6a') der Wanne (5; 5') um einen Wert lateral zueinander versetzt sind, der der Breite eines Wärmerohrs (4; 4') entspricht, wodurch ein gewundener Strömungsweg zwischen angrenzenden Wärmerohren (4; 4') für die pulsierende Wärmerohrfunktion erzeugt wird,
**dadurch gekennzeichnet, dass**
die Wanne (5) rechteckig ist und die Enden (4a) der Wärmerohre (4) abgeschnittene Enden (4a) mit einem Winkel aufweisen, wenn in einer Richtung senkrecht zur ersten Seite (A) betrachtet, wobei beide Schnittenden (4a) an den Wärmerohren (4) im Wesentlichen denselben Schnittwinkel aufweisen, wobei durch das Abwechseln der Ausrichtung von zwei angrenzenden Wärmerohren (4) dreieckige Verbindungs- oder Strömungsräume (7) zwischen zwei gegenüberliegenden, im Wesentlichen geraden Kanten (6a, 6b) der Wanne (5) und zugehörigen angewinkelten Schnittenden (4a) der Wärmerohre (4) ausgebildet werden, wobei ein gewundener Strömungsweg zwischen angrenzenden Wärmerohren (4) für die pulsierende Wärmerohrfunktion erzeugt wird, oder
die Enden (4') der Wärmerohre (4) in einem rechten Winkel (β) senkrecht zu einer durch die Wärmerohre (4') definierten Längsrichtung, wenn in einer Richtung senkrecht zur ersten Seite (A) betrachtet, geschnitten werden und die zugehörigen gegenüberliegenden Kanten (6a', 6b') der Wanne (5) Aussparungen (8') aufweisen, wobei die Breite der Aussparungen (8') im Wesentlichen der Breite der zwei Wärmerohre (4') entspricht, wobei die Verbindungs- oder Strömungsräume (7') zwischen den Aussparungen (8') ausgebildet sind und geraden Schnittenden (4a') der Wärmerohre (4') entsprechen, wodurch ein gewundener Strömungsweg zwischen angrenzenden Wärmerohren (4') für die pulsierende Wärmerohrfunktion erzeugt wird.

2. Der Wärmeverteiler nach Anspruch 1, wobei jede Aussparung (8') eine Wand (8a') aufweist, die ein Abschnitt eines Zylinders ist, wenn in einer Richtung senkrecht zur ersten Seite (A) betrachtet.

3. Der Wärmeverteiler nach einem der Ansprüche 1 oder 2, wobei jedes Wärmerohr (4; 4') ein extrudiertes Flachrohr ist, das eine Schicht nebeneinander angeordneter Kapillarkanäle (9; 9') aufweist.

4. Der Wärmeverteiler nach einem der Ansprüche 1 bis 3, wobei die Wärmerohre (4; 4') extrudierte Mehrfachanschlussleitungen sind.

5. Der Wärmeverteiler nach einem der Ansprüche 1 bis 4, wobei die erste Seite (A) der Grundplatte (2; 2'), die die Wärmerohre (4; 4') enthält, hermetisch abgedichtet angeordnet ist.

6. Der Wärmeverteiler nach einem der Ansprüche 1 bis 5, wobei die erste Seite (A) der Grundplatte (2; 2'), die die Wärmerohre (4; 4') enthält, so angeordnet ist, dass sie an einem Wärmetauscher befestigt werden kann, der die erste Seite (A) der Grundplatte (2; 2') abschließt, wobei der Wärmetauscher aus einer Gruppe ausgewählt ist, die mindestens einen Luftkühlkörper, einen Wasserkühler und ein passives Zwei-Phasen-Kühlsystem enthält.

7. Leistungsmodul, das einen Wärmeverteiler nach einem der vorstehenden Ansprüche umfasst, wobei ein elektrisches Bauteil (3) an der zweiten Seite (B) der Grundplatte (2; 2') befestigt ist, sodass das elektrische Bauteil thermisch mit der Grundplatte (2; 2') verbunden ist; und wobei ein Wärmetauscher an der ersten Seite (A) thermisch befestigt ist.

## Revendications

1. Un dissipateur thermique (1 ; 1'), comprenant :
une plaque de base (2 ; 2') pour recevoir une charge calorifique venant d'au moins un composant électrique (3), cette plaque de base comprenant des tuyaux à chaleur pulsée (4 ; 4') pour un écoulement de fluide agencé à l'intérieur de ceux-ci,
la plaque de base (2 ; 2') ayant un premier côté (A) et un deuxième côté (B) qui est en face du premier côté (A) ;
les tuyaux à chaleur pulsée comportant une pluralité de tubes à chaleur à plusieurs canaux (4 ; 4') qui sont encastrés côte à côte sur le premier côté (A) de la plaque de base (2 ; 2') ; et
le deuxième côté (B) de la plaque de base (2 ; 2') étant prévu pour attacher les composants électriques (3),
un bac (5 ; 5') s'étendant perpendiculairement au premier côté (A) étant formé pour les tubes à chaleur (4, 4') sur le premier côté (A) de la plaque de base (2 ; 2'), ce bac (5 ; 5') ayant des bords (6a, 6b, 6c, 6d ; 6a', 6b', 6c', 6c') dont la hauteur correspond à la hauteur ou à l'épaisseur des tubes à chaleur encastrés (4, 4'), deux bords opposés (6a, 6b ; 6a', 6b') du bac (5 ; 5') et les extrémités à plusieurs voies correspondantes (4 ; 4') des tubes à chaleur (4, 4') formant des espaces d'écoulement adjacents (7 ; 7') entre deux tubes à chaleur (4, 4') adjacents à la fois et une distance latérale entre deux espaces d'écoulement adjacents (7 ; 7') correspondant à la largeur de deux tubes à chaleur (4, 4'), et ces espaces d'écoulement (7 ; 7') sur les côtés opposés (6a ; 6a') du bac (5 ; 5') étant décalés latéralement l'un par rapport à l'autre pour une quantité qui correspond à la largeur d'un tube à chaleur (4 ; 4'), créant ainsi une voie d'écoulement en forme de serpentin entre des tubes à chaleur (4, 4') adjacents pour remplir la fonction des tuyaux à chaleur pulsée,
**caractérisé en ce que**
le bac (5) est rectangulaire et les extrémités (4a) des tubes à chaleur (4) ont des extrémités coupées (4a) avec un angle quand on regarde dans une direction perpendiculairement au premier côté (A), les deux extrémités coupées (4a) sur chaque tube à chaleur (4) ayant essentiellement le même angle de coupe, dans lequel, en alternant l'orientation de deux tubes à chaleur (4) adjacents, un raccordement ou des espaces d'écoulement (7) triangulaires sont formés entre deux bords opposés essentiellement droits (6a, 6a) du bac (5) et les extrémités coupées à un angle correspondantes (4a) des tubes à chaleur (4), créant ainsi une voie d'écoulement en forme de serpentin entre des tubes à chaleur (4) adjacents pour remplir la fonction des tuyaux à chaleur pulsée, ou
les extrémités (4') des tubes à chaleur (4) sont coupées à angle droit (β) perpendiculairement à une direction longitudinale définie par les tubes à chaleur (4') lorsqu'on regarde dans une direction perpendiculairement au premier côté (A) et les bords opposés correspondants (6a', 6b') du bac (5) ont des évidements (8'), la largeur de chaque évidement (8') correspondant essentiellement à la largeur de deux tubes à chaleur (4'), le raccordement ou les espaces d'écoulement (7') étant formés entre ces évidements (8') et les extrémités coupées droites correspondantes (4a') des tubes à chaleur (4'), créant ainsi une voie d'écoulement en forme de serpentin entre des tubes à chaleur (4') adjacents pour remplir la fonction des tuyaux à chaleur pulsée.

2. Le dissipateur thermique selon la revendication 1, dans lequel
chaque évidement (8') a une paroi (8a') qui est un secteur d'un cylindre quand on regarde dans une direction perpendiculairement au premier côté (A).

3. Le dissipateur thermique selon une des revendications 1 ou 2, dans lequel
chaque tube à chaleur (4 ; 4') est un tube plat extrudé qui a une couche de canaux de dimension capillaire juxtaposés (9 ; 9').

4. Le dissipateur thermique selon une des revendications 1 à 3, dans lequel
les tubes à chaleur (4, 4') sont des conduits extrudés à voies multiples.

5. Le dissipateur thermique selon une des revendications 1 à 4, dans lequel
le premier côté (A) de la plaque de base (2 ; 2') contenant les tubes à chaleur (4, 4') est agencée de façon à être fermée hermétiquement.

6. Le dissipateur thermique selon une des revendications 1 à 5, dans lequel
le premier côté (A) de la plaque de base (2 ; 2') contenant les tubes à chaleur (4, 4') est agencé de façon à être attaché à un échangeur de chaleur qui ferme le premier côté (A) de la plaque de base (2 ; 2'), cet échangeur de chaleur étant sélectionné parmi un groupe contenant au moins un puits thermique, un refroidisseur à eau et un système de refroidissement passif à deux phases.

7. Module de puissance comprenant un dissipateur thermique selon l'une quelconque des revendications précédentes, dans lequel un composant électrique (3) est attaché au deuxième côté (B) de la plaque de base (2 ; 2') de manière à ce que ce composant électrique soit raccordé thermiquement à la plaque de base (2 ; 2') ; et dans lequel un échangeur de chaleur est attaché thermiquement au premier côté (A).
